# EUROPEAN PATENT APPLICATION

(11) **EP 1 296 045 A2**
(43) Date of publication of application: **26.03.2003**
(21) Application number: 02256447.0
(22) Date of filing: 17.09.2002
(51) Int. Cl.: F02D 31/00, F02D 41/02, F01D 25/26

(54) **Electronic engine controller**

(30) Priority: 24.09.2001 GB 0122956; 18.10.2001 GB 1251131
(71) Applicant: Lucas Industries Limited, West Midlands B90 4LA (GB)
(72) Inventor: Coleman, David, Stratford-upon-Avon, Warwicksh. CV37 0DR (GB)
(74) Representative: Beck, Simon Antony

(57) **Abstract**

A controller (18) is provided in which an independent protection controller (38) is provided in a casing (8), which casing (8) is disposed within the casing (4) for the main controller (18), such that the protection controller (38) is provided as a box within a box. This allows the casing (4) for the main controller (18) to provide extra protection to the protection controller (38) against mechanical stress and damage.

## Description

The present invention relates to an electronic engine controller for use in controlling the speed of a gas turbine engine. The controller is particularly suited for use within an avionics environment.

It is known to provide electronic engine control (EEC) to control the speed and thrust of gas turbine engines used in an aircraft. These devices are generally very reliable and this reliability is further enhanced by the provision of dual channel redundancy within such controllers.

There have been reports of instances where an aircraft has left the runway due to thrust control malfunction (TCM) problems. The potential for extended stopping distances or lateral deviations caused by excessive thrust being developed by one engine of a multi-engined aircraft has the potential for causing aircraft damage and loss of life.

According to the present invention, there is provided an electronic engine controller for controlling an engine, the controller comprising a controller housed within a first casing, and an independent protection device housed within a second casing, the second casing being enclosed by the first casing.

The present invention provides additional electronic channels which monitor the engine control provided by the existing controller channels and which take a recovery action in the event of faults leading to thrust control malfunction and other engine hazards. Thus the independent protection device provides additional control capability which augments that of the controller (the controller provides primary engine control and can be thought of as a main or primary controller).

It is thus possible to provide an electronic engine controller in which an independent protection device is provided as part of the engine controller in order to prevent thrust control malfunction conditions arising as a consequence of failure in the electronic engine control, which conditions may give rise to a loss of ability of the aircraft to provide continued safe flight and landing. The independent protection device is itself physically located at the site of, and indeed within, the casing of the controller. This has particular advantage within the space constrained avionics environment since siting of an independent box away from the controller is often very difficult because of the need to identify a suitably sized space in which to house the box and also the need to provide protected wiring paths such that the necessary power and data cables can be routed to and from the second box. The independent protection device can be provided as an independent protection module.

An advantage conferred by the present invention is that the case for the controller (electronic engine controller) acts to provide physical protection for the second casing which houses the independent protection device. Thus, the second casing does not have to be as physically strong as it would need to be if the casing was sited remotely from the controller. Thus, there is a weight saving to be gained by placing the casing for the protection device within the casing of the controller. Similarly the casing of the controller provides additional protection against fire damage or damage from debris.

Preferably the controller is an electronic engine controller for a gas turbine engine and the independent protection device is provided to limit the engine speed.

Advantageously the independent protection device is arranged to limit the engine speed to a predetermined maximum. Additionally and/or alternatively, the protection device may be arranged to limit the engine speed to a value based on a pilot's command input. Thus, for example, the maximum engine speed may be controlled as a function of the pilot's throttle position.

Preferably the independent protection device has at least one power supply which is independent of the power supply provided to the controller. Preferably the data paths between the protection device and the devices with which it needs to interface are also independent of the data paths between the control channels of the electronic engine controller and the devices with which the controller needs to interface. Thus in the event of failure of the controller, the operation of the independent protection device is not compromised.

Preferably the power for the independent protection module is derived from a permanent magnet generator.

Preferably the independent protection device comprises at least two channels with each channel being able to monitor the operation of the other. Advantageously, whilst both channels are working correctly, agreement must be obtained between the channels before engine thrust control can be implemented via the protection device. However, in the event of failure of one of the protection channels, then the other channel can assume full authority for protection of the engine. It is possible that further channels could be provided in the independent protection module.

The independent protection device benefits from both mechanical and electrical segregation from the control channels of the electronic engine controller. Such segregation ensures that operation of the independent protection device is not affected by faults which may occur within the control channels of the electronic engine controller (this is why the device can be regarded as functionally independent). Such faults may include printed circuit board failures such as board delamination, solder splashes causing shorting between components, loose screws, swarf in the connectors or power supply failures.

According to a second aspect of the present invention there is provided an electronic engine controller comprising a primary controller for providing primary control of an engine, the primary controller being housed within a first casing; and a secondary controller for providing protection against control malfunction of the primary controller, the secondary controller located within a second casing which is enclosed by the first casing.

The present invention will further be described, by way of example, with reference to the accompanying drawings, in which:
Figure 1 is a perspective view of an electronic engine controller constituting an embodiment of the present invention;
Figure 2 schematically illustrates the relationship between the control channels of the electronic engine controller and the protection device;
Figure 3 schematically illustrates an embodiment of the present invention in greater detail;
Figure 4 schematically illustrates the casing for the protection device used in combination with the electronic engine controller illustrated in Figure 1; and
Figure 5 is a cross-sectional view through the controller of Figure 1.

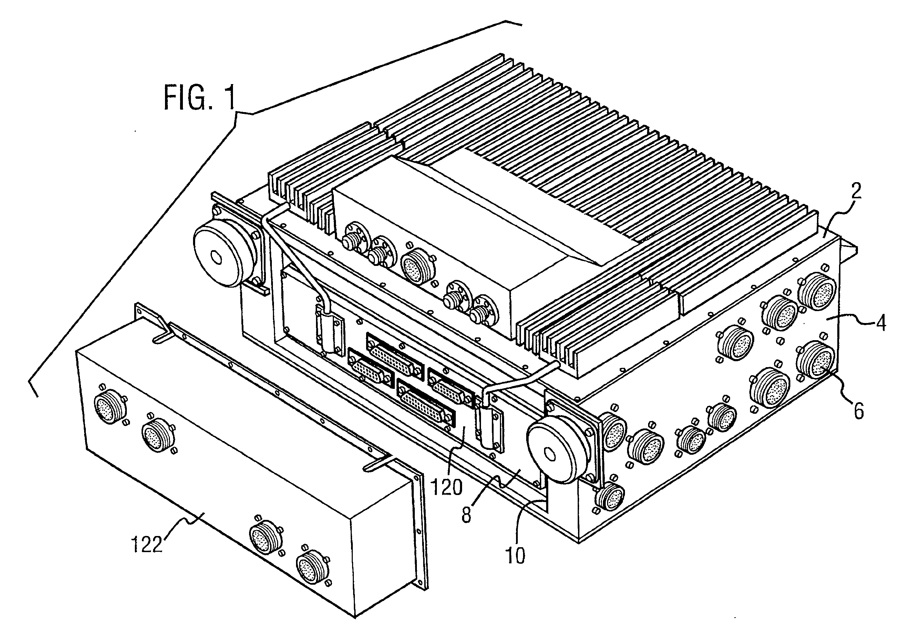

Figure 1 schematically illustrates a full authority digital engine controller module which is suitable for use in an aircraft. The controller 2 comprises a first case 4 which provides a sealed enclosure for the electronics of the engine controller. The thickness of the walls of the casing 4 is selected so as to provide the desired levels of rigidity, resistance to impact, and blast protection deemed appropriate by the designer. Electrical connections between the controller circuitry and the aircraft are made via connectors 6 of types well known to the person skilled in the art.

The case 4 has a closed recess formed therein. That is to say, the recess forms a bay into which an auxiliary protection device can be inserted, but the recess itself does not provide a path between the environment external to the casing 4 and the environment internal to the casing. As shown in Figure 1, a protection device enclosed within its own casing 8 is inserted into the recess 10 in the casing 4 in order that the casing 4 surrounds and protects the protection device and its casing 8.

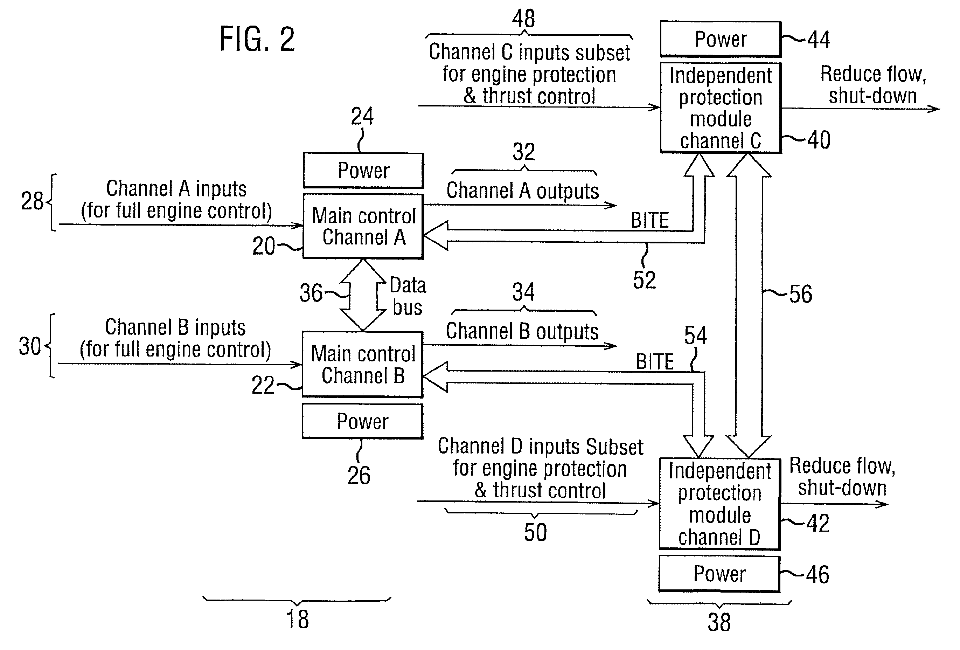

As shown in Figure 2, the controller 18 comprises two main control channels 20 and 22. The first channel 20 has a power supply 24 associated uniquely with it. Similarly, the second channel 22 has a power supply 26 associated uniquely with it. Thus failure of the power supply of either channel does not cause the entire control system to fail. Each of the channels 20 and 22 also has its own set of inputs 28 and 30, which will be described in greater detail hereinafter. The first channel 20 has a plurality of outputs 32 for controlling the various fuel control valves associated with the engine. Similarly, the second channel 22 has an equivalent set of outputs 34 for performing the same task. The channels 20 and 22 are interconnected by a data bus 36 which enables them to exchange data in order that they can confirm that each other channel is working, and monitor the performance of each other's sensors and the like in a manner which is known to the person skilled in the art.

The protection device 38 (which can also be regarded as a protection module) comprises first and second independent protection channels 40 and 42. The first independent protection channel 40 is associated uniquely with power supply 44, whereas the second independent protection channel 42 has its own power supply 46. These power supplies are independent of the power supplies 24 and 26 associated with the first and second channels of the controller. The power supplies may be derived from a permanent magnet alternator,

PMA. The PMA has a dedicated winding for each one of the channels 20, 22 of the controller 18, ie main control channels A and B, and dedicated windings for each of the channels 40, 42 of the independent protection module 38. Thus there are four separate windings in total. Each winding is fed through its own dedicated connector and harness to the respective individual connectors of the electronic engine controller and the independent protection module. Thus failure of any one of the power supplies does not affect more than one controller channel or one protection channel. The first protection channel 40 receives a plurality of inputs for monitoring the performance of the engine such that it has sufficient data to perform engine over-speed/over-thrust protection. These inputs are indicated 48 on Figure 2. Similarly a second set of inputs 50 are provided to the second protection channel 42.

Although the electronics of the protection device/module 38 is effectively isolated from the electronics of the controller 18, nevertheless it is advantageous to have a limited connection between the protection device and the controller 18 such that each can monitor, but not influence, the health of the other. Thus limited electrical connection between the first channel 20 of the controller and the first channel 40 of the protection module is provided via a built in test equipment (BITE) connection 52. Similarly a second BITE connection 54 extends between the second channel 22 of the controller and the second channel 42 of the protection module. The first and second channels 40 and 42 of the protection module also have a data exchange path 56 between the channels, for example, in the form of a serial bus, such that each may monitor the health of the other, and if necessary, can also swap data between the channels.

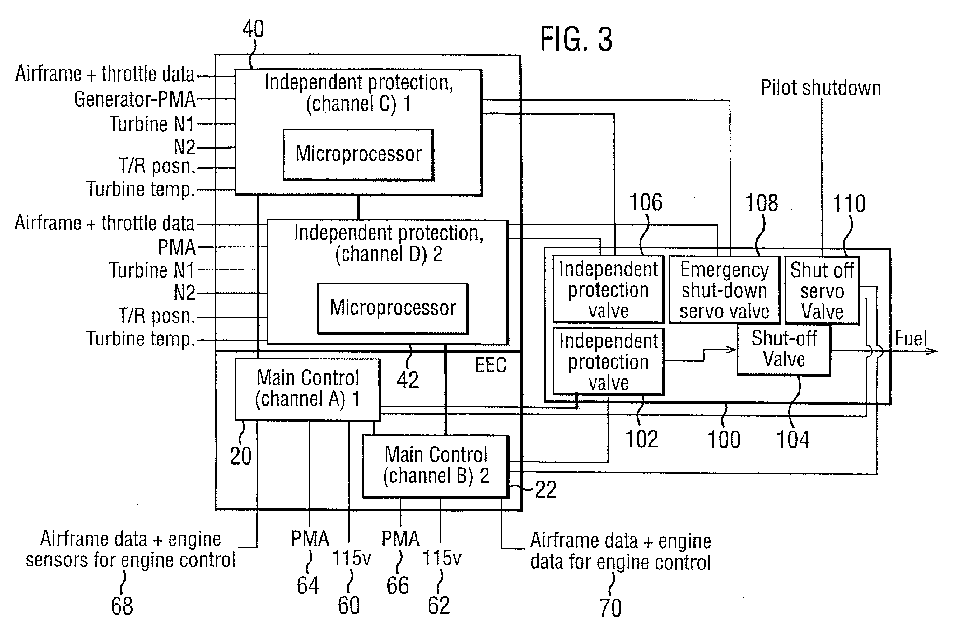

Figure 3 schematically illustrates the interconnection between the electronic engine controller, the various aircraft sensors, and a fuel metering unit which controls the supply of fuel to the gas turbine engine.

Each of the main control channels 20 and 22 receives an independent electrical supply 60 and 62, an independent indication of the speed of an electrical generator associated with the gas turbine engine via inputs 64 and 66, respectively, and a plurality of other input data via data buses 68 and 70, respectively, including pilot throttle position, engine turbine temperature, spool speeds of the various shafts within the engine and so on.

Each of the control channels 20 and 22 has an output to the fuel metering unit 100. The fuel metering unit regulates the supply of fuel to the gas turbine engine and includes, amongst other things a servo controlled metering and dump valve 102, a shutoff valve 104, an independent protection valve 106 in series with the metering servo valve 102 for providing additional protection against excess fuel flow rate, an emergency shut down servo valve 108 and a pilot operated shut down servo valve 110 thereby giving the pilot ultimate authority to shut down the engine.

The main controllers 20 and 22 have independent outputs to the servo controlled metering valve 102, and the shutoff servo valve 110. This in turn gives them control over the shut off valve 104. In use, either one of the first and second channels 20 and 22 acts as a master controlling the engine speed, whereas the other operates in a standby or "ready but not active" mode.

Each of the channels 40 and 42 of the independent protection module receives a limited set of data independent from the main control channels sufficient to enable it to fulfil its overspeed protection task. The data includes data derived from the aircraft airframe, such as the pilot controlled throttle position and also data derived from the flight control surfaces, such as the high lift surfaces such that the controller can deduce when the aircraft is in relatively low level flight, for example during approach or takeoff, and also optional data from undercarriage sensors such that the independent protection module can deduce when the aircraft is on the runway. Each of the protection channels also receives an indication of engine shaft speeds, turbine temperature, generator speed and thrust reverser position. These inputs are used by a microprocessor based data controller in order to derive appropriate limits for engine speed and thrust, and also to derive what action is to be taken under various circumstances.

Each of the protection devices has independent outputs to the independent protection valve 106 and also to the emergency shut down servo valve 108 which allows control to be obtained over the shut off valve 104.

Depending on the situation, the independent protection module has the ability to either reduce fuel flow to the engine or shut the engine down.

In the event of a thrust control malfunction occurring while the aircraft is on the ground, if both controllers 40 and 42 concur that an over thrust has occurred under these conditions then they also act to shut the engine down. In the event that a thrust control malfunction is detected during an aircraft approach to the runway during the landing procedure then engine shut down is not appropriate but reduction of engine power is and consequently the independent protection valve 106 is operated to modify the fuel flow to the engine.

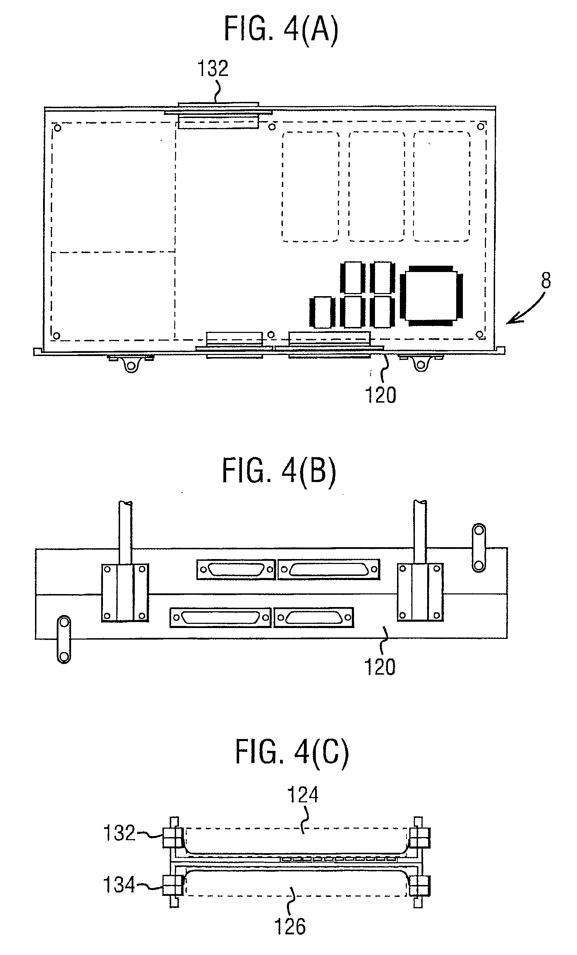

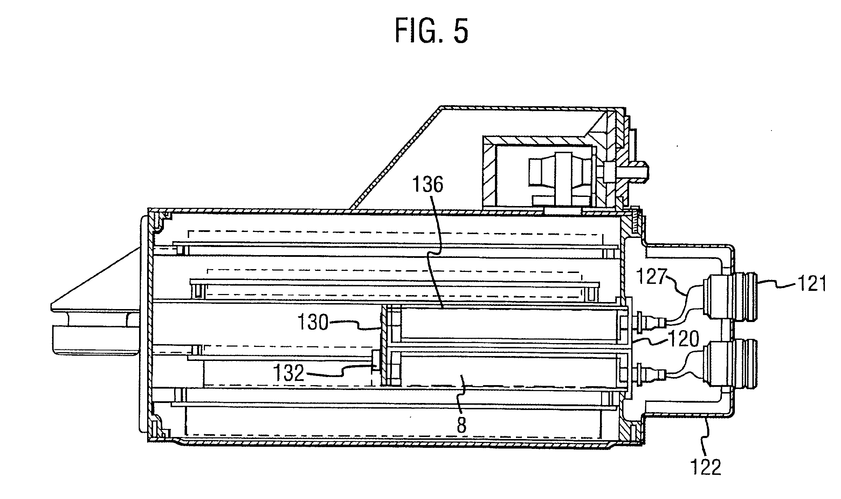

Figure 4 schematically illustrates the arrangement of the casing for the protection modules used in the digital engine controller shown in Figure 1. In particular, Figure 4 shows the casing 8 in both plan view and as viewed from the front end of the casing which forms the panel 120 of connectors shown in Figure 1 and as viewed from the side. Figure 5 shows a side view of the main controller case 4 with a further cover 122 for the independent protection module, which shields the independent protection module in the event of a fire around the case 4 of the controller. Connection extensions 127 run between connectors provided in the panel 120 of the casing and the connectors 121 provided on a cover plate 122 shown in Figure 5. Consequently the spaces 124 and 126 (Figure 4) allocated for the electronics of the first and second protection channels are indeed wholly enclosed within the boundary delimited by the case 4 and none of the walls defining these spaces are in direct contact with the environment surrounding the case 4. As also shown, the inboard face 130 of the casing 8 carries connectors 132 for making the BITE connections to the first and second channels of the primary controller.

It is thus possible to provide an electronic engine controller in which an independent protection module is situated within an independent casing held within the casing of the main engine controller. This "box within a box" concept means that a casing of the main controller can provide mechanical and fire protection for the casing of the independent protection module thereby allowing the second casing to be lighter and less rigid. Thus the casing 8 can have much thinner walls than would be required if it were positioned outside of the controller casing 4. This has advantages in terms of weight of the entire system, and also advantages in terms of routing the data and power connections to the auxiliary/overspeed controller. In order to enhance thermal isolation between the controller and the independent protection module, a gap or a separation box 136 may be provided between the main controller and the independent protection module 8.

## Claims

1. An electronic engine controller for controlling an engine, the controller comprising a controller (18) housed within a first casing (4), **characterised in that** an independent protection device (38) is housed within a second casing (8), and that the second casing (8) is enclosed by the first casing (4).

2. An electronic engine controller as claimed in claim 1, **characterised in that** the engine controller (18) is a controller for a gas turbine engine and the independent protection device (38) is provided to limit engine speed.

3. An electronic engine controller as claimed in clam 1 or 2, **characterised in that** the independent protection device (38) has a power supply (44; 46) which is independent of the power supply (24; 26) to the controller (18).

4. An electronic engine controller as claimed in claim 3, **characterised in that** the independent protection device (38) receives control data independently from the controller.

5. An electronic engine controller as claimed in any one of the preceding claims, **characterised in that** the independent protection device (38) comprises at least two channels (40; 42) independently processing data, and two channels have to be in agreement to alter the engine speed or fuelling before such a modification to engine operation is implemented.

6. An electronic engine controller as claimed in any one of the preceding claims, **characterised in that** the first casing (4) provides support and protection for the second casing (8).

7. An electronic engine controller as claimed in claim 6, **characterised in that** the walls of the second casing (8) are thinner than the walls of the first casing (4).

8. An electronic engine controller as claimed in any one of the preceding claims, **characterised in that** the independent protection device (38) receives and/or sends data via connectors which are independent of the controller (18).

9. An electronic engine controller as claimed in any one of the preceding claims, **characterised in that** the independent protection device (38) has two channels (40; 42) therein, and in the event of failure of one channel the other channel assumes responsibility for thrust malfunction protection.

10. An electronic engine controller as claimed in any one of claims 1 to 9, in which the first casing defines a recess into which the second casing can be inserted and removed.

11. An electronic engine controller as claimed in claim 10, in which a cover is provided to shield the second casing from a environment surrounding the first casing.

12. An engine including an electronic engine controller as claimed in any one of the preceding claims.

13. An engine as claimed in claim 12, **characterised in that** each channel (40; 42) of the independent protection device (38) receives power from a respective winding of an aircraft electrical generator.

14. An engine as claimed in claim 13, **characterised in that** the generator is a permanent magnet generator.
